# EUROPEAN PATENT SPECIFICATION

(11) **EP 3 595 015 B1**
(45) Date of publication and mention of the grant of the patent: **24.01.2024**
(21) Application number: 17903178.6
(22) Date of filing: 19.04.2017
(51) Int. Cl.: H01L 31/0224, H01L 31/05

(54) **SOLAR SHINGLE ASSEMBLY EMPLOYING CENTER-CONVERGING FINGERS CONVERGING TOWARD ELECTRODE**
SOLARSCHINDELANORDNUNG MIT MITTIG ZUSAMMENLAUFENDEN FINGERN, DIE ZUR ELEKTRODE ZUSAMMENLAUFEN
ENSEMBLE DE BARDEAUX SOLAIRES UTILISANT DES DOIGTS À CONVERGENCE CENTRALE CONVERGEANT VERS UNE ÉLECTRODE

(30) Priority: 30.03.2017 CN 201710203952
(43) Date of publication of application: 15.01.2020
(73) Proprietor: Longi Solar Technology Co., Ltd, Xi'an Shaanxi 710018 (CN)
(72) Inventor: ZHENG, Zhi, Shanghai 200003 (CN); MIAO, Jinfei, Taizhou Jiangsu 225300 (CN)
(74) Representative: Manitz Finsterwald Patent- und Rechtsanwaltspartnerschaft mbB
(86) International application number: PCT/CN2017/081143
(87) International publication number: WO 2018/176527

(56) References cited:
- WO-A1-00/31803
- CN-A- 102 403 373
- CN-A- 106 531 829
- CN-U- 203 521 434
- CN-U- 204 927 301
- US-A- 4 430 519
- US-A1- 2011 254 117
- US-A1- 2016 197 207
- US-A1- 2017 077 343

## Description

### FIELD OF TECHNOLOGY

The disclosure belongs to the field of solar cell technologies, and more particularly, to a shingled solar cell module employing a centrally converged grid line electrode.

### BACKGROUND

A solar cell is a device that converts light energy directly into direct current using a photovoltaic effect. According to different photoelectric conversion materials, the solar cells include monocrystalline silicon, polycrystalline silicon, amorphous silicon film, cadmium telluride film, copper indium gallium tin film, gallium arsenide, fuel sensitization, perovskite, shingled solar cells, and other types. The crystalline silicon solar cells are the most common solar cells, including monocrystalline silicon solar cells and polycrystalline silicon solar cells. The solar cell is usually in a sheet form. One side of the solar cell that can absorb light energy and convert it into electric energy is called a light absorbing side or a front side, and the other side is called a back side. For some solar cells, the back sides thereof may also absorb and convert light energy into electric energy. These solar cells are called double-sided cells.

A photovoltaic device that can be used for long-term use by electrically interconnecting a plurality of solar cells and then packaging the cells into a glass or organic polymer is called a photovoltaic module. A common method of interconnecting the cell slices in the crystalline silicon photovoltaic module is to arrange the cell slices in sequence, use a tin-coated solder strip containing a copper substrate as an interconnecting strip, weld one end of the interconnecting strip on a main grid line in a front side of a first cell slice, and weld the other end of the interconnecting strip on a grid line in a back side of an adjacent second cell slice. The two ends of a second interconnecting strip are respectively welded on a main grid line in a front side of the second cell slice and a back electrode of a third cell slice, and so on. In this way, all the cell slices are connected in series into one string.

A shingled solar cell module employs another technique for interconnecting cell slices. One side of a solar cell slice A is placed under another cell slice B, so that a main grid line electrode on a front side of the cell slice A and an electrode on a back side of the cell slice B are overlapped with each other. The two electrodes are conductively connected by using a conductive material. Meanwhile, the other side of the cell slice B is placed under a cell slice C, so that a main grid line electrode on a front side of the cell slice B and an electrode on a back side of the cell slice C are overlapped with each other, and the two electrodes are conductively connected by using a conductive material. In the same way, a plurality of cell slices can be sequentially interconnected to form a cell strings.

Electrode patterns on the front and back sides of the shingled cell slice are prepared by metallizing the surface of the solar cell. A common metallization method is to print a conductive paste containing silver particles on the surface of the cell by screen printing and sintering, and the electrode pattern can be changed by adjusting the screen graphics design of the screen printing.

In addition to an electrode region, a front surface of a crystalline silicon solar cell usually employs a silicon nitride film, and employs a screen printed aluminum paste in a back side usually. For some special solar cells, such as double-sided cells with both front and back side capable of absorbing light, surfaces of the regions other than the back electrode also employ a silicon nitride film instead of aluminum paste.

A conductive material between the electrodes of the cell slice in the shingled solar cell module includes a conductive adhesive, a solder strip or a solder paste, etc. Corresponding preparation methods should be selected according to the characteristics of the conductive material. For a cell string electrically interconnected by conductive adhesive, dispensing or printing can be used.

Main components of the conductive adhesive used in photovoltaic products include a resin matrix and a metal filler. The metal filler usually refers to silver or silver-containing particles. Compared with a common tin-coated copper strap, the conductive adhesive can not only form good mechanical adhesion and conductive connection with a silver paste, but also form good adhesion with other surfaces of the cell slice, such as silicon nitride film layer or silicon material.

Since silver is a precious metal, the costs of paste and conductive adhesive of a silver-containing solar cell are relatively high. At present, there are some technologies for preparing paste or conductive adhesive of solar cells by replacing silver with other metals, but the mainstream technologies in the market are still silver paste and silver conductive adhesive.

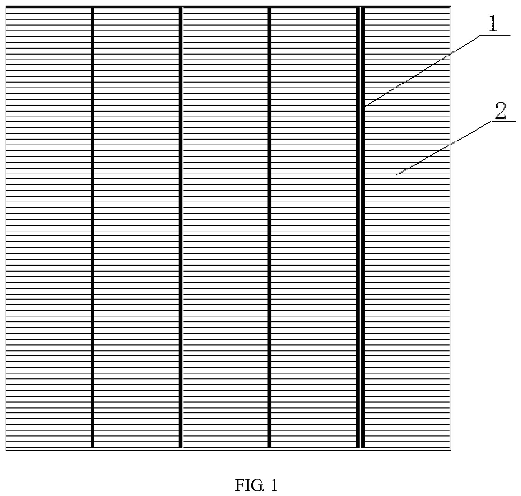

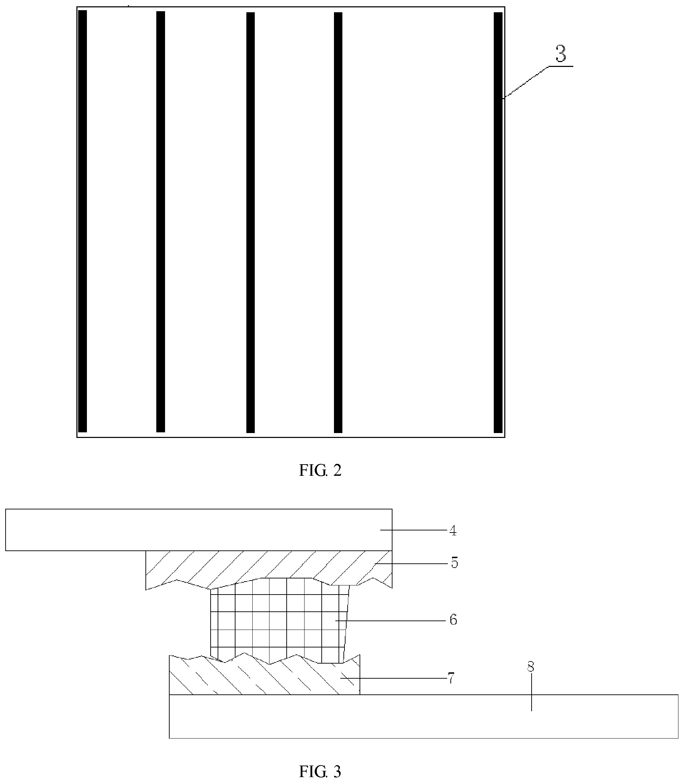

FIG 1 is a design solution of a front electrode of a shingled cell. FIG 2 is a design solution of a back electrode of the shingled cell. The shingled cell in FIG 1 may be a large solar cell, and it may be cut into several pieces. As shown in FIG 1, the shingled cell is cut for five pieces. In FIG 1 and FIG 2, the reference numeric 1 refers to a main grid line in a front side, 2 refers to a fine grid line in a front side, 3 refers to a main grid line in a back side. As shown in FIG 1 and FIG 2, each shingled cell slice will be cut into five small slices in subsequent steps, with one main grid line electrode on one side of a front side and one back electrode on the other side of a back side of each small slice. This technical solution is characterized in that all the main grid line electrodes and the back electrodes are made of silver paste in a solid rectangle. FIG 3 is a schematic diagram of an interconnection solution between adjacent cells after the cells employing the technical solution are made into a photovoltaic module. The reference numeric 4 in FIG 3 refers to a first sub-cell, 5 refers to a back electrode, 6 refers to conductive adhesive, 7 refers to a front electrode, 8 refers to a second sub-cell. As shown in FIG 3, the first sub-cell 4 and the second sub-cell 8 are electrically communicated through conductive adhesive. The shingled module formed in FIG 3, and the structure formed by sub-cells shingled with each other are called "shingled solar cell module" in the invention.

In the solution of the prior art, the consumption of the silver paste of the main grid line electrode is larger, and the consumption of the conductive adhesive is also larger, so the material cost is higher, and the photovoltaic power generation cost is higher.

Another disadvantage is that a length of the secondary grid line in the conventional solution is long, so the resistance loss of the secondary grid line is large, resulting in low photoelectric conversion efficiency of the cell.

In addition to the solutions mentioned above, there are other design solutions for the electrodes of the shingled cells. Each cell can be cut into two, three, four, six, seven or eight slices in addition to five small slices. For chamfered monocrystalline silicon cell slices, an electrode design decision similar to that of FIG 1 and FIG 2 is employed, and the chamfered and unchamfered slices are respectively formed into a cell string. For square monocrystalline silicon or polycrystalline silicon cell slices, the conventional solutions include the one in which all the front electrodes are located on a right side of the slice and all the back electrodes are located on a left side of the slice, i.e., a front electrode of a rightmost slice in FIG. 1 is moved to a right end of the slice, and a back electrode of the same slice is moved to a left end of the slice. What these electrode design solutions have in common is that all the front and back electrodes used are solid and successive silver electrodes in a rectangle pattern. Therefore, all these design solutions have the defects of large consumption of silver paste and high cost. US 2017/077343 A1 discloses a shingled solar cell module. WO0031803 A1, US4430519 A, CN102403373 A and US2016197207 disclose different centrally converged front electrode patterns that are used in the field of solar cells.

### SUMMARY

The disclosure aims to provide a shingled solar cell module employing a centrally converged grid line electrode, which is a high-efficiency low-cost electrode design solution for shingled cells, and the structure uses less silver paste and conductive adhesive than a traditional shingled solar cell module.

In order to achieve the above objects, a technical solution of the present invention is set out in the claims.

A shingled solar cell module employing a centrally converged grid line electrode includes a plurality of sub-cells employing a centrally converged grid line electrode, wherein a front side of each sub-cell includes a plurality of front-side main electrode points and secondary grid lines; the plurality of front-side main electrode points are distributed along a long edge of a sub-cell slice, and the secondary grid line forms a divergent pattern centering on the front-side main electrode points, and converging currents to the front-side main electrode points in a way of converging from periphery to center; a back side of the sub-cell is provided with back-side main electrode points which is one-to-one corresponding to the front-side main electrode points; the front-side main electrode points and the back-side main electrode points of the same sub-cell are respectively distributed along two opposite long edges; and edges of adjacent sub-cells are overlapped, main electrode points of a first sub-cell and main electrode points in a back side of a second sub-cell are connected through conductive adhesive, and the first sub-cell and the second sub-cell are adhered and fixed through the conductive adhesive.

The secondary grid lines are divided into a plurality of secondary grid line groups distributed annularly from inside to outside by centering on the main electrode points, wherein an inner end of a first type secondary grid line of a first type secondary grid line group is connected with the main electrode points, and an outer end of the first type secondary grid line is connected with two second type secondary grid lines of a second type secondary grid line group, and the two second type secondary grid lines are connected with three type third secondary grid lines of a third type secondary grid line group, thus forming the divergent pattern by analogy in turn; and currents of every three third type secondary grid lines are converged to two second type secondary grid lines, currents of every two second type secondary grid lines are converged to one first type secondary grid line and then converged to the main electrode points.

Adjacent secondary grid line groups are also connected through arc-shaped secondary grid lines centering on the main electrode points.

The secondary grid lines are provided with different cross-sectional areas according to different currents passing by, and the secondary grid line with a larger current has a larger cross-sectional area; and the cross-sectional area is adjusted through a width and a height.

The secondary grid lines corresponding to adjacent main electrode points are cut off from extending after being intersected.

In different secondary grid line groups, a cross-sectional area of a corresponding grid line of the secondary grid line group close to the main electrode points is larger than a cross-sectional area of a corresponding grid line of the secondary grid line group far away from the main electrode points;

or, in the same secondary grid line group, a cross-sectional area of a grid line not connected with another secondary grid line group is smaller than a cross-sectional area of a grid line connected with another secondary grid line group;

or, the closer the same secondary grid line to the main electrode points, the larger a corresponding cross-sectional area of the grid line is.

The main electrode points in the front side and the main electrode points in the back side of the same sub-cell are respectively distributed along two opposite long edges; and the electrode points of two adjacent sub-cells are arranged at the same side or at different sides of the sub-cells.

The back side and the front side of the sub-cell have the same structure, both of which employ the centrally converged grid line electrode.

The back side of the sub-cell employs a structure that the back-side secondary grid lines is vertical to a main grid line in the back side; and the main grid line in the back side is connected with all the back-side main electrode points.

All or a part of an overlapped region between the first sub-cell (4) and the second sub-cell (8) except the area connected by the conductive adhesive (6) is adhered by non-conductive adhesive (11)..

Compared with the prior art, the disclosure has the following effects.

According to the shingled solar cell module of the disclosure, the edges of the adjacent sub-cells are overlapped, the main electrode points of the first sub-cell and the main electrode points in the back side of the second sub-cell are electrically connected through the conductive adhesive. The first sub-cell and the second sub-cell are adhered together by the conductive adhesive meanwhile. The method for adhering and fixing is simple, and is convenient to operate. In particular, the centrally converged grid line electrode is employed in the front side or the back side of the solar shingled cell, and the secondary grid line with the electrode structure is a divergent pattern centering on the main electrode points, and converging currents to the main electrode points in a way of converging from periphery to center. The structure that the main grid and the secondary grid are vertical in the prior art is changed, and the structure can reduce the light shielding area of the electrode in the front side of the cell and improve the utilization of the light energy in the front side of the cell. The solar shingled cell introduces a front electrode winding technology into a back passivation cell technology, so that the two high-efficiency crystalline silicon cell technologies are better combined, achieving an effects obviously better than using one of the two technologies alone. The front side of the cell is improved by reducing the light shielding area of the electrode in the front side of the cell; and meanwhile, a passivation film on the back side of the cell preferably solves the leakage problem in metal winding. In addition, a local aluminum electrode on the back side of the cell is changed into an aluminum fine grid line, so that the cell has the function of generating electricity on both sides.

Further, in order to enhance an adhesion strength between the first sub-cell and the second sub-cell, all or a part of an overlapped region between the first sub-cell and the second sub-cell except the main electrode points may be adhered by non-conductive adhesive.

Further, a group of secondary grid lines converged to each main electrode point on the front side of the cell are divergent patterns centering on the main electrode point, and spacing between adjacent secondary grid lines increases with the increase of a length to the secondary grid lines. The number of the secondary grid lines is increased at a position far from the main electrode point, thereby reducing the spacing between the secondary grid lines at that position. The further the secondary grid lines is away from the main electrode point, the larger the number of the secondary grid lines is, therefore the circuit converging efficiency is provided.

Further, the cross-sectional area of the grid line may be increased in order to reduce resistance loss of the grid lines. To the secondary grid lines further away from the main electrode points, the cross-sectional area of the grid line may be relatively smaller because a current flowing through the sub-grid line is smaller. For the same kind of secondary grid lines, the cross-sectional areas of the grid lines are different due to different currents passing by. The same secondary grid line may also have different cross-sectional areas. The closer to the main electrode point, the greater the current passing by the secondary grid line is, and the greater the corresponding cross-sectional area of the grid line is. As the number and the cross-sectional area of the secondary grid lines are optimized, the photoelectric conversion efficiency of the shingled cell slices with such patterns is improved in comparison with the conventional shingled cell slices with parallel secondary grid lines.

Further, the areas of the main grid line electrodes in the front and back sides of the solar cell are reduced, thereby reducing the consumption of the silver paste and the conductive adhesive.

### BRIEF DESCRIPTION OF THE DRAWINGS

FIG 1 is a schematic diagram of a front electrode of a current shingled cell;
FIG 2 is a schematic diagram of a back electrode of the current shingled cell;
FIG 3 is a schematic diagram of a conductive adhesive pattern of the current shingled cell;
FIG 4 is a schematic diagram of a front electrode pattern according to an embodiment of the present invention;
FIG 5 is a schematic diagram of a back electrode pattern according to an embodiment of the present invention;
FIG 6 is a diagram of a shingled cell structure formed by two sub-cells with conductive adhesive according to an embodiment of the present invention;
FIG 7 is an exploded schematic diagram of a shingled cell structure formed by two sub-cells with conductive adhesive according to an embodiment of the present invention;
FIG 8 is an exploded schematic diagram of a shingled cell structure with non-conductive adhesive according to an embodiment of the present invention;
FIG 9 is a schematic diagram of an optimized secondary grid line of a cell slice according to an embodiment of the present invention;
FIG 10 is a schematic diagram of an optimized secondary grid line of a cell slice according to an embodiment of the present invention;
FIG 11 is a schematic diagram of an optimized secondary grid line of a cell slice according to an embodiment of the present invention;
FIG 12 is a segmented schematic diagram of a back electrode according to an embodiment of the present invention;
FIG 13 is a schematic diagram of a centrally converged grid line of a chamfered cell slice according to an embodiment of the present invention;
FIG 14 is a schematic diagram of a grid line pattern in a front side of a shingled cell with six slices according to an embodiment of the present invention; and
FIG 15 is a schematic diagram of a grid line pattern in a front side of a shingled cell with five slices according to an embodiment of the present invention.

1 refers to a main grid line in a front side, 2 refers to a fine grid line in a front side, 3 refers to a main grid line in a back side, 4 refers to a first sub-cell, 5 refers to a back electrode, 6 refers to conductive adhesive, 7 refers to a front electrode, 8 refers to a second sub-cell, 9 refers to a secondary grid line, 10 refers to a main electrode point in a front side, 11 refers to non-conductive adhesive, 12 refers to a first type secondary grid line, 13 refers to a second type secondary grid line, 14 refers to an arc-shaped secondary grid line, 15 refers to a third type secondary grid line, 16 refers to a chambered structure, 17 refers to a main electrode point in a back side, and 18 refers to a fine grid line in a back side, which is the secondary grid line in the back side.

### DESCRIPTION OF THE EMBODIMENTS

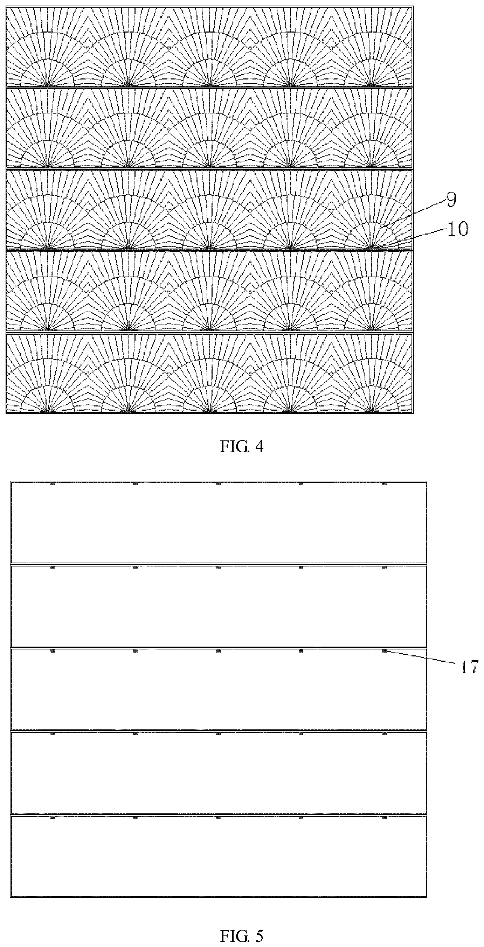

As shown in FIG 4 and FIG 5, a cell slice is divided into a plurality of sub-cells. Secondary grid lines on a front side of each sub-cell are divided into several groups. On the front side of the sub-cell, each group of secondary grid lines 9 converge currents to respective main electrode points 10 in a way of converging to center; and each main electrode point 10 is distributed along one long side of the sub-cell. A back electrode of the cell is corresponding to the main electrode points 10 in the front side one by one, which also presents in the form of main electrode points 17. The main electrode points 10 in the front side and the main electrode points 17 in the back side of the same sub-cell are respectively distributed along two opposite long edges.

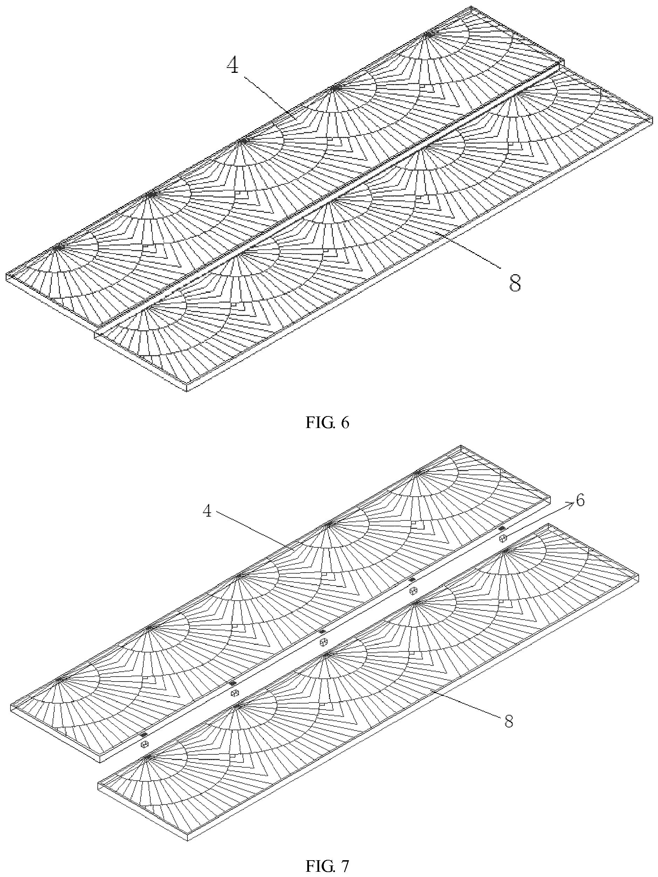

As shown in FIG 6 and FIG 7, edges of adjacent sub-cells in a shingled solar cell module are overlapped. Referring to FIG 3 to FIG 5,the main electrode points 10 in a front side of a first sub-cell 4 and main electrode points 17 in a back side of a second sub-cell 8 are electrically connected through conductive adhesive 6. By the electrical connection between the main electrode points, the first sub-cell 4 and the second sub-cell 8 are adhered together by the conductive adhesive 6 meanwhile.

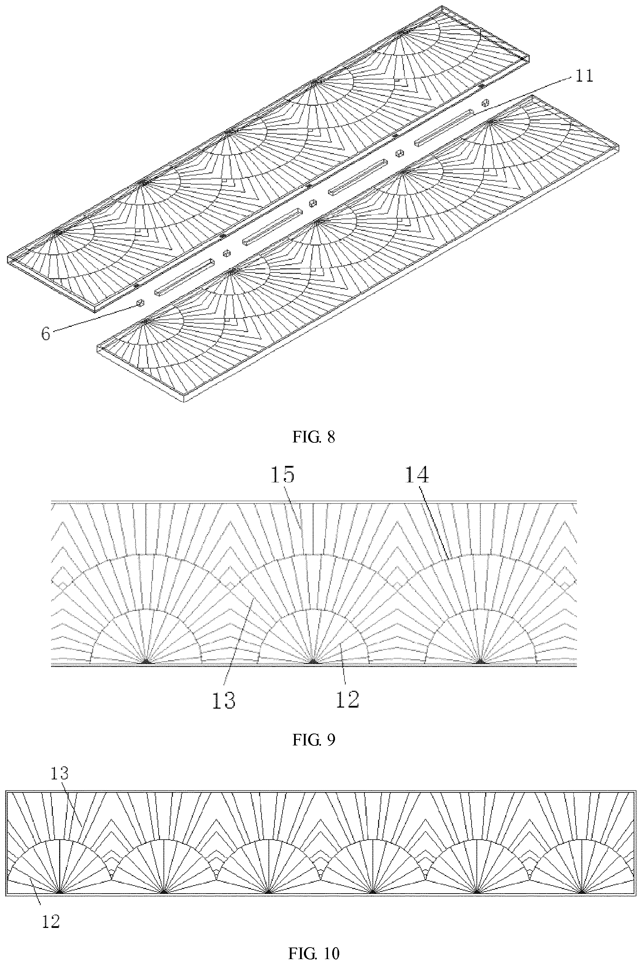

As shown in FIG 8, in order to enhance an adhesion strength between the first sub-cell 4 and the second sub-cell 8, all or a part of an overlapped region between the first sub-cell 4 and the second sub-cell 8 except the main electrode points may be adhered by non-conductive adhesive 11.

Referring to FIG 4, a group of secondary grid lines converged to each main electrode point on the front side of the cell is a divergent pattern centering on the main electrode point 10, and spacing between adjacent secondary grid lines increases with the increase of a length of the secondary grid lines 9. An optimized solution is to increase the amount of secondary grid lines at a position far from the main electrode point 10, thereby reducing the spacing between the secondary grid lines at that position. As shown in FIG 9, the secondary grid lines in FIG 9 are divided into four types, an amount of a first type secondary grid line 12 closest to the main electrode point is small, and an included angle between two adjacent secondary grid lines is large; an amount of a second type secondary grid lines 13 slightly away from the main electrode point 10 is large, and currents of every two second type secondary grid lines are converged to one first type secondary grid line 12; a density of a third type secondary grid lines 15 farthest from the main electrode point is higher, and current of every three third type secondary grid lines 15 are converged to two arc-shaped second type secondary grid lines 13. Adjacent secondary grid lines of the same kind are connected by an arc-shaped secondary grid line 14.

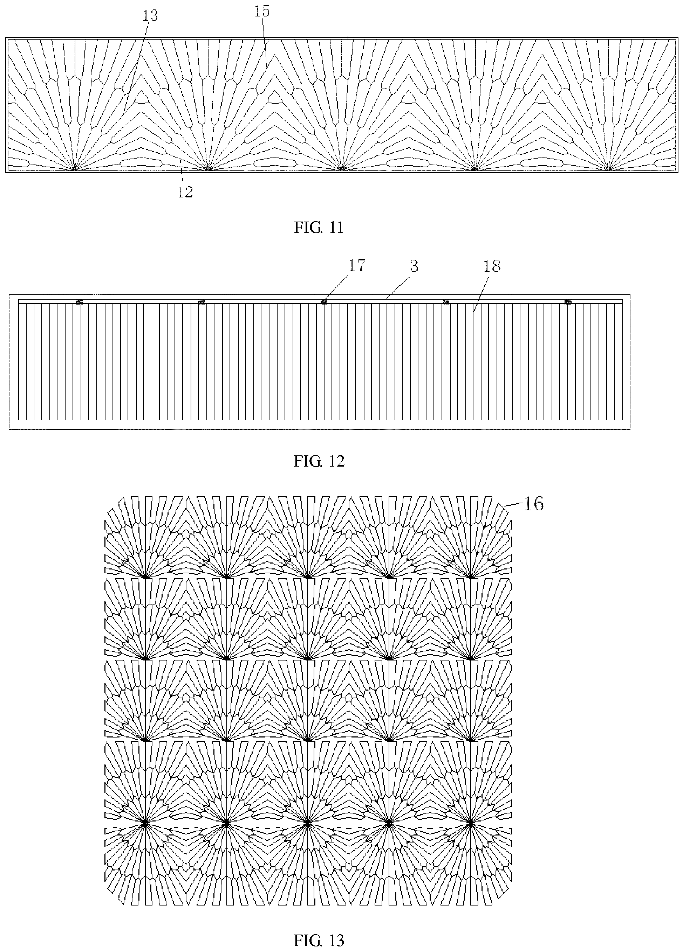

FIG 10 and FIG 11 are other optimized solutions for secondary grid lines. The secondary grid lines in FIG 10 are divided into two types according to the distance to the main electrode point 10. Adjacent secondary grid lines FIG 11 are directly interconnected to each other without passing through other secondary grid lines.

For the secondary grid line close to the main electrode point, the cross-sectional area of the secondary grid line may be larger in order to reduce the resistance loss of the grid line due to a larger current passing by. For the secondary grid line far from the main electrode point, the cross-sectional area of the grid line may be relatively smaller due to a smaller current passing by. The cross-sectional area of the grid line may be adjusted by changing a width or a height of the grid line. The solution of changing the width of the grid line is shown in FIG 11. The width of the first type secondary grid line 12 is larger than the widths of the second type secondary grid line 13 and the third type secondary grid line 15.

For the same type of secondary grid lines, the cross-sectional areas of the grid lines may also be different due to different currents passing by. The secondary grid line with a larger current may have a larger cross-sectional area. As shown in FIG 11, the grid lines have the same heights, but the current of the third type secondary grid line is converged on the second type secondary grid line 13 in the region above the main electrode point 10, so the width of the second type secondary grid line 13 in the region above the main electrode point may be larger than the width of the second type secondary grid lines 13 at left and right sides of the main electrode point 10 without being converged by the third type secondary grid lines.

The same secondary grid line 9 may also have different cross-sectional areas. The closer to the main electrode point 10, the greater the current passing by the secondary grid line is, and the greater the corresponding cross-sectional area of the grid line is.

For a double-sided cell, a back side of the cell may employ a similar way of converging fine grid lines 18 to main electrode points 17 as a front side of the cell, or may employ other ways such as a conventional way of setting the fine grid lines 18 perpendicular to the main grid lines 3, similar to the grid line pattern in FIG 1. In the latter way, other parts of a main grid line 3 in the back side, excluding main electrode points 17 in the back side corresponding to positions of main electrode points 10 in the front side, may adopt a hollowed-out pattern design, as shown in FIG 12.

The above-mentioned design solution may also be applied to a chamfered cell slice, as shown in FIG 13, which illustrates a design of a front electrode for a chamfered shingled cell slice. A pattern of the secondary grid line electrode at the chamfered portion is adjusted to form a corresponding chambered structure 16.

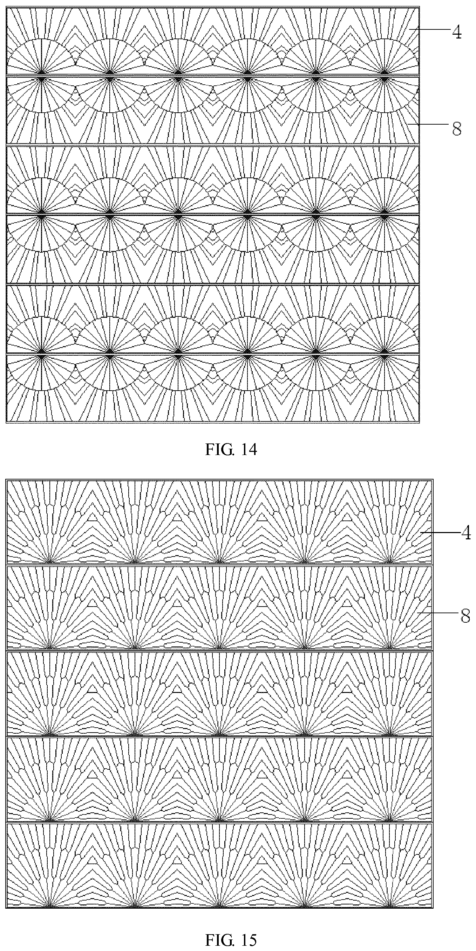

For the electrode pattern design of the shingled cells, besides the solution of cutting a monolithic cell into 5 slices, a design solution of cutting the monolithic cell into two, three, four, six, seven or eight slices may also be employed. FIG 14 illustrates one of the solutions to cut the monolithic cell into six slices.

The main electrode points 10 on the same side of two adjacent sliced cells may either be adjacent, as shown in FIG 14, or not adjacent, as shown in FIG 4.

FIG 15 illustrates a grid line pattern of a monolithic solar cell designed using the grid line pattern of the sliced cell in FIG 11.

According to the design solution, the areas of the main grid line electrodes in the front and back sides of the solar cell are reduced, thereby reducing the consumption of the silver paste and the conductive adhesive. Moreover, as the number and the cross-sectional area of the secondary grid lines are optimized, the photoelectric conversion efficiency of the shingled cell slices with such patterns is improved in comparison with the conventional shingled cell slices with parallel secondary grid lines.

The disclosure may not only be applied to conventional crystalline silicon solar cells and PERC (Passivated Emitter and Rear Cell) solar cells, but also be applied to heterojunction cells, PERL(Passivated Emitter and Rear Locally-diffused) cells, PERT T (Passivated Emitter, Rear Totally-diffused cell) cells, TOPCon cells and other cell technologies.

A preparation method of the cell slice is the same as that of the conventional shingled cell slice, wherein silk screen printing is employed in the electrode grid lines, and screen printing plates for silk screen printing are manufactured according to the pattern in the disclosure.

When testing the efficiency of the cell slice, a front probe needs to contact the main electrode point, and a back probe or copper plate also needs to contact the main electrode point.

After the cell slice is prepared, the cell slice may be divided into several small slices by laser or mechanical scribing. The conductive adhesive is coated on the main electrode points by silk screen printing or dispensing, and then the cell slices are overlapped with each other to form a laminated structure.

## Claims

1. A shingled solar cell module, comprising a plurality of sub-cells employing a centrally converged grid line electrode, wherein a front side of each sub-cell comprises a plurality of front-side main electrode points (10) and secondary grid lines (9); the plurality of front-side main electrode points (10) are distributed along a long edge of the sub-cell, and the secondary grid line (9) forms a divergent pattern centering on the front-side main electrode points (10), and converging currents to the front-side main electrode points (10); a back side of the sub-cell is provided with back-side main electrode points (17) which is one-to-one corresponding to the front-side main electrode points (10) ; the front-side main electrode points (10) and the back-side main electrode points (17) of the same sub-cell are respectively distributed along two opposite long edges; and edges of adjacent sub-cells are overlapped, the front-side main electrode points (10) of a first sub-cell (4) and the back-side main electrode points (17) of a second sub-cell (8) are connected through conductive adhesive (6); **characterised in that** the secondary grid lines (9) are divided into a plurality of secondary grid line groups distributed annularly from inside to outside by centering on the main electrode points (10), an inner end of a first type secondary grid line (12) of a first type secondary grid line group is connected with the main electrode points (10), and an outer end of the first type secondary grid line (12) is connected with two second type secondary grid lines (13) of a second type secondary grid line group, and the two second type secondary grid lines (13) are connected with three third type secondary grid lines (15) of a third type secondary grid line group, thus forming the divergent pattern by analogy in turn; so that currents of every three third secondary type grid lines (15) are converged to two second type secondary grid lines (13), currents of every two second type secondary grid lines (13) are converged to one first type secondary grid line (12) and then converged to the main electrode points (10).

2. The shingled solar cell module according to claim 1, wherein adjacent secondary grid line groups are connected through arc-shaped secondary grid lines (14) centering on the main electrode points (10).

3. The shingled solar cell module according to claim 1 or 2, wherein the secondary grid lines (9) are provided with different cross-sectional areas according to different currents passing by, and the secondary grid line with a larger current has a larger cross-sectional area; and the cross-sectional area is adjusted through changing a width and a height of the secondary grid line.

4. The shingled solar cell module according to any one of claims 1-3, wherein the secondary grid lines (9) corresponding to adjacent main electrode points (10) are cut off from extending after being intersected.

5. The shingled solar cell module according to any one of claims 1-4, wherein in different secondary grid line groups, a cross-sectional area of a corresponding grid line of the secondary grid line group close to the main electrode points (10) is larger than a cross-sectional area of a corresponding grid line of the secondary grid line group far away from the main electrode points (10);
or, in the same secondary grid line group, a cross-sectional area of a grid line not connected with another secondary grid line group is smaller than a cross-sectional area of a grid line connected with another secondary grid line group;
or, the closer a secondary grid line to the main electrode points (10), the larger a corresponding cross-sectional area of the grid line of the secondary grid line is.

6. The shingled solar cell module according to any one of claims 1-5, wherein the front-side main electrode points (10) and the back-side main electrode points (17) of the same sub-cell are respectively distributed along two opposite long edges; and the main electrode points (10) of two adjacent sub-cells are arranged at the same side or at different sides of the sub-cells.

7. The shingled solar cell module according to any one of claims 1-6, wherein the back side and the front side of the sub-cell have the same structure, both of which employ the centrally converged grid line electrode.

8. The shingled solar cell module according to any one of claims 1-7, wherein the back side of the sub-cell employs a structure that the back-side secondary grid lines (18) is vertical to a main grid line (3) in the back side; and the main grid line (3) in the back side is connected with all the back-side main electrode points (17).

9. The shingled solar cell module according to any one of claims 1-8, wherein all or a part of an overlapped region between the first sub-cell (4) and the second sub-cell (8) except the area connected by the conductive adhesive (6) is adhered by non-conductive adhesive (11).

## Patentansprüche

1. Geschindeltes Solarzellenmodul, das eine Vielzahl von Unterzellen umfasst, die eine zentral konvergierende Gitterlinienelektrode verwenden, wobei eine Vorderseite jeder Unterzelle eine Vielzahl von Vorderseiten-Hauptelektrodenpunkten (10) und sekundäre Gitterlinien (9) umfasst; die Vielzahl von Vorderseiten-Hauptelektrodenpunkten (10) entlang einer langen Kante der Unterzelle verteilt ist und die sekundäre Gitterlinie (9) ein divergentes Muster bildet, das auf die Vorderseiten-Hauptelektrodenpunkte (10) zentriert ist und Ströme an die Vorderseiten-Hauptelektrodenpunkte (10) konvergieren lässt; eine Rückseite der Unterzelle mit Rückseiten-Hauptelektrodenpunkten (17) versehen ist, die eins-zu-eins den Vorderseiten-Hauptelektrodenpunkten (10) entsprechen; die Vorderseiten-Hauptelektrodenpunkte (10) und die Rückseiten-Hauptelektrodenpunkte (17) der gleichen Unterzelle jeweils entlang zweier gegenüberliegender langer Kanten verteilt sind; und Kanten benachbarter Unterzellen überlappt sind, die Vorderseiten-Hauptelektrodenpunkte (10) einer ersten Unterzelle (4) und die Rückseiten-Hauptelektrodenpunkte (17) einer zweiten Unterzelle (8) durch leitenden Klebstoff (6) verbunden sind; **dadurch gekennzeichnet, dass**
die sekundären Gitterlinien (9) in eine Vielzahl von sekundären Gitterliniengruppen unterteilt sind, die ringförmig von innen nach außen verteilt sind, indem sie auf die Hauptelektrodenpunkte (10) zentriert sind, ein inneres Ende einer sekundären Gitterlinie (12) eines ersten Typs einer sekundären Gitterliniengruppe eines ersten Typs mit den Hauptelektrodenpunkten (10) verbunden ist, und ein äußeres Ende der sekundären Gitterlinie (12) des ersten Typs mit zwei sekundären Gitterlinien (13) eines zweiten Typs einer sekundären Gitterliniengruppe des zweiten Typs verbunden ist, und die zwei sekundären Gitterlinien (13) des zweiten Typs mit drei sekundären Gitterlinien (15) eines dritten Typs einer sekundären Gitterliniengruppe eines dritten Typs verbunden sind, wodurch das divergente Muster der Reihe nach analog gebildet wird; so dass Ströme von allen drei sekundären Gitterlinien (15) des dritten Typs zu zwei sekundären Gitterlinien (13) des zweiten Typs konvergieren, Ströme von allen zwei sekundären Gitterlinien (13) des zweiten Typs zu einer sekundären Gitterlinie (12) des ersten Typs konvergieren und dann zu den Hauptelektrodenpunkten (10) konvergieren.

2. Geschindeltes Solarzellenmodul nach Anspruch 1, wobei benachbarte sekundäre Gitterliniengruppen durch bogenförmige sekundäre Gitterlinien (14) verbunden sind, die auf die Hauptelektrodenpunkte (10) zentriert sind.

3. Geschindeltes Solarzellenmodul nach Anspruch 1 oder 2, wobei die sekundären Gitterlinien (9) mit unterschiedlichen Querschnittsflächen entsprechend den verschiedenen vorbeifließenden Strömen versehen sind und die sekundäre Gitterlinie mit einem größeren Strom eine größere Querschnittsfläche aufweist; und die Querschnittsfläche durch Ändern einer Breite und einer Höhe der sekundären Gitterlinie eingestellt wird.

4. Geschindeltes Solarzellenmodul nach einem der Ansprüche 1 bis 3, wobei Verlängerungen der sekundären Gitterlinien (9), die benachbarten Hauptelektrodenpunkten (10) entsprechen, nach dem Kreuzen abgeschnitten werden.

5. Geschindeltes Solarzellenmodul nach einem der Ansprüche 1 bis 4, wobei in verschiedenen sekundären Gitterliniengruppen eine Querschnittsfläche einer entsprechenden Gitterlinie der sekundären Gitterliniengruppe nahe den Hauptelektrodenpunkten (10) größer ist als eine Querschnittsfläche einer entsprechenden Gitterlinie der sekundären Gitterliniengruppe weit entfernt von den Hauptelektrodenpunkten (10);
oder in derselben sekundären Gitterliniengruppe eine Querschnittsfläche einer nicht mit einer anderen sekundären Gitterliniengruppe verbundenen Gitterlinie kleiner ist als eine Querschnittsfläche einer mit einer anderen sekundären Gitterliniengruppe verbundenen Gitterlinie;
oder, je näher eine sekundäre Gitterlinie an den Hauptelektrodenpunkten (10) liegt, desto größer eine entsprechende Querschnittsfläche der Gitterlinie der sekundären Gitterlinie ist.

6. Geschindeltes Solarzellenmodul nach einem der Ansprüche 1 bis 5, wobei die Vorderseiten-Hauptelektrodenpunkte (10) und die Rückseiten-Hauptelektrodenpunkte (17) derselben Unterzelle jeweils entlang zweier gegenüberliegender langer Kanten verteilt sind; und die Hauptelektrodenpunkte (10) zweier benachbarter Unterzellen auf derselben Seite oder auf verschiedenen Seiten der Unterzellen angeordnet sind.

7. Geschindeltes Solarzellenmodul nach einem der Ansprüche 1 bis 6, wobei die Rückseite und die Vorderseite der Unterzelle die gleiche Struktur aufweisen, wobei alle beide die zentral konvergierende Gitterlinienelektrode verwenden.

8. Geschindeltes Solarzellenmodul nach einem der Ansprüche 1 bis 7, wobei die Rückseite der Unterzelle eine Struktur verwendet, bei der die rückseitigen sekundären Gitterlinien (18) rechtwinklig zu einer Hauptgitterlinie (3) auf der Rückseite verlaufen; und die Hauptgitterlinie (3) auf der Rückseite mit allen Rückseiten-Hauptelektrodenpunkten (17) verbunden ist.

9. Geschindeltes Solarzellenmodul nach einem der Ansprüche 1 bis 8, bei dem der gesamte oder ein Teil eines überlappenden Bereichs zwischen der ersten Unterzelle (4) und der zweiten Unterzelle (8) mit Ausnahme der durch den leitfähigen Klebstoff (6) verbundenen Fläche mit einem nicht leitfähigen Klebstoff (11) verklebt ist.

## Revendications

1. Module de cellules solaires en bardeaux, comprenant une pluralité de sous-cellules employant une électrode à lignes de grille à convergence centrale, dans lequel une face avant de chaque sous-cellule comprend une pluralité de points d'électrode principaux de face avant (10) et de lignes de grille secondaires (9) ; la pluralité de points d'électrode principaux de face avant (10) sont répartis le long d'un bord long de la sous-cellule et la ligne de grille secondaire (9) forme un motif divergent centré sur les points d'électrode principaux de face avant (10), qui fait converger les courants vers les points d'électrode principaux de face avant (10) ; une face arrière de la sous-cellule est pourvue de points d'électrode principaux de face arrière (17) correspondant un à un aux points d'électrode principaux de face avant (10) ; les points d'électrode principaux de face avant (10) et les points d'électrode principaux de face arrière (17) de la même sous-cellule sont respectivement répartis le long de deux bords longs opposés ; et les bords de sous-cellules adjacentes se chevauchent, les points d'électrode principaux de face avant (10) d'une première sous-cellule (4) et les points d'électrode principaux de face arrière (17) d'une deuxième sous-cellule (8) sont connectés par un adhésif conducteur (6) ;
**caractérisé en ce que**
les lignes de grille secondaires (9) sont divisées en une pluralité de groupes de lignes de grille secondaires répartis annulairement de l'intérieur vers l'extérieur en étant centrés sur les points d'électrode principaux (10), une extrémité intérieure d'une ligne de grille secondaire de premier type (12) d'un groupe de lignes de grille secondaires de premier type est connectée aux points d'électrode principaux (10), et une extrémité extérieure de la ligne de grille secondaire de premier type (12) est connectée à deux lignes de grille secondaires de deuxième type (13) d'un groupe de lignes de grille secondaires de deuxième type, et les deux lignes de grille secondaires de deuxième type (13) sont connectées à trois lignes de grille secondaires de troisième type (15) d'un groupe de lignes de grille secondaires de troisième type, formant ainsi le motif divergent par analogie tour à tour ; de sorte que les courants de toutes les trois lignes de grille secondaires de troisième type (15) convergent vers deux lignes de grille secondaires de deuxième type (13), les courants de toutes les deux lignes de grille secondaires de deuxième type (13) convergent vers une ligne de grille secondaire de premier type (12) et convergent ensuite vers les points d'électrode principaux (10).

2. Module de cellules solaires en bardeaux selon la revendication 1, dans lequel des groupes de lignes de grille secondaires adjacents sont connectés par des lignes de grille secondaires en forme d'arc (14) centrées sur les points d'électrode principaux (10).

3. Module de cellules solaires en bardeaux selon la revendication 1 ou 2, dans lequel les lignes de grille secondaires (9) sont pourvues de différentes surfaces de section transversale en fonction des différents courants qui passent, la ligne de grille secondaire avec un courant plus important ayant une plus grande surface de section transversale ; et la surface de section transversale est ajustée en modifiant la largeur et la hauteur de la ligne de grille secondaire.

4. Module de cellules solaires en bardeaux selon l'une quelconque des revendications 1 à 3, dans lequel les lignes de grille secondaires (9) correspondant à des points d'électrode principaux adjacents (10) cessent de s'étendre après avoir été croisées.

5. Module de cellules solaires en bardeaux selon l'une quelconque des revendications 1 à 4, dans lequel, dans des groupes de lignes de grille secondaires différents, une surface de section transversale d'une ligne de grille correspondante du groupe de lignes de grille secondaires proche des points d'électrode principaux (10) est plus grande qu'une surface de section transversale d'une ligne de grille correspondante du groupe de lignes de grille secondaires éloigné des points d'électrode principaux (10) ;
ou, dans le même groupe de lignes de grille secondaires, une surface de section transversale d'une ligne de grille non connectée à un autre groupe de lignes de grille secondaires est plus petite qu'une surface de section transversale d'une ligne de grille connectée à un autre groupe de lignes de grille secondaires ;
ou plus une ligne de grille secondaire est proche des points d'électrode principaux (10), plus une surface de section transversale correspondante de la ligne de grille de la ligne de grille secondaire est grande.

6. Module de cellules solaires en bardeaux selon l'une quelconque des revendications 1 à 5, dans lequel les points d'électrode principaux de face avant (10) et les points d'électrode principaux de face arrière (17) de la même sous-cellule sont respectivement répartis le long de deux bords longs opposés ; et les points d'électrode principaux (10) de deux sous-cellules adjacentes sont disposés sur le même côté ou sur des côtés différents des sous-cellules.

7. Module de cellules solaires en bardeaux selon l'une quelconque des revendications 1 à 6, dans lequel la face arrière et la face avant de la sous-cellule ont la même structure, toutes deux employant l'électrode à lignes de grille à convergence centrale.

8. Module de cellules solaires en bardeaux selon l'une quelconque des revendications 1 à 7, dans lequel la face arrière de la sous-cellule emploie une structure dans laquelle les lignes de grille secondaires de face arrière (18) sont verticales par rapport à une ligne de grille principale (3) sur la face arrière ; et la ligne de grille principale (3) sur la face arrière est connectée à tous les points d'électrodes principaux de face arrière (17).

9. Module de cellules solaires en bardeaux selon l'une quelconque des revendications 1 à 8, dans lequel la totalité ou une partie d'une zone de chevauchement entre la première sous-cellule (4) et la deuxième sous-cellule (8), à l'exception de la zone connectée par l'adhésif conducteur (6), est collée par un adhésif non conducteur (11).
